(19) **Europäisches Patentamt / European Patent Office / Office européen des brevets**

(11) **EP 3 103 178 B1**

(12) **FASCICULE DE BREVET EUROPEEN**

(45) Date de publication et mention
de la délivrance du brevet:
**11.10.2017 Bulletin 2017/41**

(21) Numéro de dépôt: **15702470.4**

(22) Date de dépôt: **03.02.2015**

(51) Int Cl.:
**H02H 1/00** *(2006.01)*

(86) Numéro de dépôt international:
**PCT/EP2015/052110**

(87) Numéro de publication internationale:
**WO 2015/114151 (06.08.2015 Gazette 2015/31)**

(54) **PROCÉDÉ ET CIRCUIT DE DÉTECTION D'UN ARC ÉLECTRIQUE DANS UN CIRCUIT, ET DISPOSITIF DE COMMUTATION UTILISANT UN TEL CIRCUIT**

VERFAHREN UND SCHALTUNG ZUR ERFASSUNG EINES ELEKTRISCHEN LICHTBOGENS IN EINER SCHALTUNG UND SCHALTVORRICHTUNG MIT SOLCH EINER SCHALTUNG

METHOD AND CIRCUIT FOR DETECTING AN ELECTRIC ARC IN A CIRCUIT, AND SWITCHING DEVICE USING SUCH A CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.02.2014 FR 1450817**

(43) Date de publication de la demande:
**14.12.2016 Bulletin 2016/50**

(73) Titulaires:
• **Leach International Europe SA**
**57430 Sarralbe (FR)**
• **Université de Lorraine**
**54052 Nancy Cedex (FR)**

(72) Inventeurs:
• **TISSERAND, Etienne**
**54180 Heillecourt (FR)**
• **BOURNAT, Marc**
**57200 Sarreguemines (FR)**
• **ANDREA, Jonathan**
**88190 Golbey (FR)**
• **SCHWEITZER, Patrick**
**54180 Heillecourt (FR)**
• **WEBER, Serge**
**54600 Villers Les Nancy (FR)**

(74) Mandataire: **Novagraaf Technologies**
**16, rue Gambetta**
**25000 Besançon (FR)**

(56) Documents cités:
**EP-A2- 0 639 879      EP-A2- 1 443 622**
**US-A1- 2003 227 290      US-A1- 2008 201 021**
**US-B1- 6 504 692**

**Description**

**Domaine technique**

La présente invention se rapporte à un procédé de détection d'arc dans un circuit électrique, à un circuit de détection mettant en oeuvre ledit procédé et à un dispositif de commutation comportant un tel circuit.
Dans la description ci-dessous, les références entre crochets ([ ]) renvoient à la liste des références présentée à la fin du texte.

**Etat de la technique**

Dans les circuits électriques, certains défauts peuvent donner naissance à des arcs électriques de manière non souhaitable. On distingue principalement deux sortes de défauts.
Le premier type de défaut apparaît lorsqu'un espacement est créé entre deux éléments du circuit sur le chemin du courant. A faible tension, aucun courant ne passe, mais avec une tension qui dépend en particulier de la largeur de l'espacement, un arc s'établit dans l'espacement et le courant passe. On parle alors d'un défaut de type arc en série. Dans le cas d'un courant alternatif, un arc s'établit à chaque demi-alternance.
Le deuxième type de défaut apparaît lorsqu'un conducteur parasite tend à mettre en court-circuit la source de courant du circuit électrique. Là aussi, un espacement subsiste entre un conducteur principal et le conducteur parasite. Avec une faible tension, aucun courant ne passe entre les deux conducteurs, mais lorsque la tension augmente, un arc s'établit dans l'espacement et le courant passe en réalisant un court-circuit. Un phénomène similaire peut se produire lorsqu'un liquide conducteur mouille simultanément deux conducteurs sous potentiels différents. On parle alors d'un défaut de type arc en parallèle.
Il se produit localement un échauffement qui peut être dissipé si l'arc n'est pas fréquent, mais qui peut générer des destructions s'il se produit fréquemment ou de manière répétée. De plus, l'alimentation du circuit est affaiblie. Par ailleurs, le courant de court-circuit peut aussi échauffer le conducteur parasite et causer un incendie.
Il a déjà été proposé un dispositif de protection pour un circuit électrique comportant un dispositif de détection d'arc électrique. Le document EP 1 845 599 A1 **[1]** montre un exemple des tels dispositifs. La détection est basée sur la mesure du courant et de la tension d'alimentation du circuit électrique sur l'analyse numérique de ces signaux. Plusieurs unités de détection comparent les valeurs des signaux, de leurs dérivées et de leur intégration à des seuils pour fournir des signaux d'aide à la décision, chaque unité de détection étant adaptée à un type d'arc électrique particulier. Des moyens de décision reçoivent les signaux d'aide à la décision afin de fournir un signal de commande pour ouvrir le circuit électrique et le mettre en sécurité.
Dans un autre document **[2]**, un circuit de détection d'arc électrique est appliqué à la commande de puissance à semi-conducteurs. Dans ce document, on propose également d'utiliser des moyens de décisions recevant les résultats de plusieurs unités de détection. Dans l'une d'elles, on propose une détection par interpolation du signal d'entrée pris parmi le courant et la tension. Le signal est sous-échantillonné puis interpolé par un polynôme. Ensuite, l'interpolation est comparée avec le signal d'origine et une alerte est générée si l'écart dépasse un seuil prédéterminé.
Même si ce procédé de détection fonctionne bien, il nécessite d'effectuer de nombreux calculs complexes, ce qui nécessite un circuit de détection puissant, et donc onéreux.
Les documents US 6 504 692 B1, EP 0 639 879 A2 et EP 1 443 622 A2 décrivent des procédés et des circuit de détection de présence d'arc électrique reflétant le préambule des revendications indépendantes 1 et 6. L'invention vise à fournir un procédé de détection d'arc électrique qui soit simple à mettre en oeuvre, efficace et nécessitant peu de moyens de calculs.

**Description de l'invention**

Avec ces objectifs en vue, l'invention a pour objet un procédé de détection d'arc électrique sur un circuit électrique alimenté en courant alternatif selon une période d'alimentation, selon lequel on mesure au moins un signal d'entrée parmi un courant et une tension d'alimentation du circuit électrique, et on fournit un signal d'alerte indiquant qu'un arc électrique se produit lorsque le signal d'entrée est constant sur au moins une partie de la période d'alimentation.
Les inventeurs ont constaté que lorsqu'un arc de type série apparait dans un circuit électrique alimenté en courant alternatif, l'arc disparait lorsque le courant s'annule. Le courant reste alors sensiblement nul pendant un certain temps jusqu'à ce que la tension au niveau de l'espacement soit suffisante pour réamorcer l'arc. Le courant s'établit à nouveau et remonte brusquement. La détection de cette période pendant laquelle le courant est nul permet de caractériser la présence d'au moins un arc dans le circuit électrique. De manière similaire, avec un défaut de type parallèle, le circuit électrique est pratiquement en court circuit et la tension est alors très faible en étant sensiblement constante. La surveillance de la tension ou du courant permet de détecter l'un ou l'autre type de défaut. On entend par constant le fait que le signal se trouve par exemple dans une bande dont la largeur est petite, de l'ordre de l'amplitude d'un bruit sur le signal ou d'un bruit d'un arc électrique. On peut également définir que le signal est constant lorsque sa dérivée sur le temps est inférieure à un seuil prédéterminé. Selon l'invention, le procédé de détection d'arc électrique est caractérisé en ce que l'on échantillonne numériquement le signal d'entrée lors de sa mesure selon des niveaux prédéterminés et, pour identifier que le signal d'entrée est constant, on détermine la fréquence à laquelle chaque niveau est atteint par le signal d'entrée sur une fenêtre temporelle prédéterminée, on compare la fréquence de chaque niveau à un seuil d'alerte prédéterminé, et on délivre le signal d'alerte si la fréquence d'au moins l'un des niveaux est supérieure au seuil d'alerte. A partir de la numérisation du signal d'entrée, il est relativement aisé de quantifier la fréquence à laquelle un niveau est atteint. De là, il est également aisé de déterminer si pour au moins l'un des niveaux, la fréquence dépasse un seuil d'alerte. Si le signal d'entrée est constant pendant une certaine durée, le même niveau sera détecté plusieurs fois. A chaque mesure correspondant à ce niveau, la valeur de la fréquence est augmentée. Le dépassement d'un seuil pour la valeur de la fréquence est le signe que le signal est constant pendant une certaine durée de la période. Il n'est pas nécessaire de calculer ni intégrale ni dérivée par cette méthode, ce qui limite les besoins en calculs.

Selon une disposition constructive, on utilise une mémoire de fréquence pour stocker les fréquences des niveaux, la mémoire de fréquence comportant des registres et un premier bus d'adresse recevant la valeur échantillonnée du signal d'entrée, on utilise des moyens d'addition pour incrémenter de 1 l'un des registres pointé par la valeur fournie sur le premier bus d'adresse, on utilise en outre une mémoire premier entré-premier sorti recevant la valeur échantillonnée du signal d'entrée sur une entrée et fournissant une valeur décalée sur une sortie, un deuxième bus d'adresse de la mémoire de fréquence recevant la valeur décalée, et on utilise des moyens de soustraction pour décrémenter de 1 le registre pointé par la valeur décalée sur le deuxième bus d'adresse, l'addition, la soustraction et le décalage dans la mémoire premier entré-premier sorti étant réalisés dans un même cycle. La mémoire de fréquence permet de mémoriser pour chaque niveau le nombre de fois où le niveau est atteint par le signal d'entrée, et ce pour une période de temps déterminée par la taille de la mémoire premier entré-premier sorti et la durée d'un cycle. En effet, la mémoire d'un niveau déterminé est incrémentée lorsque ledit niveau est présenté sur le premier bus d'adresse, puis décrémentée lorsque le même niveau est présenté sur le deuxième bus d'adresse par la mémoire premier entré-premier sorti plus tard, après un nombre de cycles correspondant à la taille de la mémoire premier entré-premier sorti. Le procédé de comptage est simple car il permet d'utiliser directement une mémoire sans microcontrôleur, avec simplement un additionneur et un soustracteur, comme on le verra mieux par la suite.

De manière complémentaire, on établit d'autres signaux d'alertes selon au moins un autre procédé parmi une détection par analyse spectrale, une détection par filtre interpolateur, une méthode de différenciation temporelle, et on combine ces signaux pour déterminer une commande de coupure du circuit électrique. On est ainsi en mesure de prendre en compte différents types d'arcs électriques qui peuvent avoir des signatures différentes et donc des méthodes différentes pour les détecter. La combinaison des signaux permet également de corréler les méthodes entre elles afin d'avoir une détection fiable.

De manière particulière, le signal d'entrée est le signal de courant, la détermination de la commande de coupure prenant en compte l'intensité du signal de courant pendant l'alerte, la fréquence des signaux d'alerte et leur durée moyenne. La détection d'une occurrence d'un arc élecrique n'est pas suffisante en soi pour considérer que le circuit électrique est en danger. Cependant, plus l'intensité du courant pendant l'arc est importante et plus la durée des arcs est longue, plus on considère que le circuit est en danger et nécessite d'être protégé rapidement. Par contre, si l'intensité est faible ou si les arcs ne durent pas très longtemps, il est possible de laisser le circuit alimenté malgré les arcs.

Selon une disposition particulière, la coupure est commandée si un couple fréquence des signaux d'alerte et durée moyenne des signaux d'alerte est au-delà d'une première courbe de forme hyperbolique décroissante, ou si un couple intensité d'alerte et durée moyenne est au-delà d'une deuxième courbe de forme hyperbolique décroissante. On combine ainsi d'une part la fréquence des signaux d'alerte et la durée moyenne des signaux d'alerte et, d'autre part, l'intensité d'alerte et la durée moyenne des signaux d'alerte pour y appliquer une limite au-delà de laquelle le déclenchement du circuit électrique est commandé. On peut également exprimer la limite par le fait que le produit des deux membres du couple est inférieur à une limite. Il va de soi que ces critères s'appliquent sur une fenêtre temporelle, de telle sorte que des évènements anciens ne sont pas pris en compte.

L'invention a aussi pour objet un circuit de détection pour détecter la présence d'arc électrique sur un circuit électrique alimenté en courant alternatif selon une période d'alimentation, le circuit de détection comportant des moyens de mesure pour établir au moins un signal d'entrée parmi un signal de tension et un signal de courant représentatif respectivement de la tension et de l'intensité alimentant le circuit électrique, le circuit de détection étant agencé pour délivrer un signal d'alerte indiquant qu'un arc électrique se produit lorsque le signal d'entrée est constant sur au moins une partie de la période d'alimentation, le circuit étant caractérisé en ce qu'il comporte des moyens d'échantillonnage pour échantillonner numériquement le signal d'entrée lors de sa mesure selon des niveaux prédéterminés et des moyens de traitement pour identifier que le signal d'entrée est constant, en déterminant la fréquence à laquelle chaque niveau est atteint par le signal d'entrée sur une fenêtre temporelle prédéterminée, en comparant la fréquence de chaque niveau à un seuil d'alerte prédéterminé, et en délivrant le signal d'alerte si la fréquence d'au moins l'un des niveaux est supérieur au seuil d'alerte. L'invention a aussi pour objet un dispositif de commutation électrique comportant des moyens de commutation pour ouvrir et fermer un circuit électrique alimenté en courant alternatif selon une période d'alimentation et un circuit de détection pour piloter les moyens de commutation, caractérisé en ce que le circuit de détection est tel que décrit précédemment.

**Brève description des figures**

L'invention sera mieux comprise et d'autres particularités et avantages apparaîtront à la lecture de la description qui va suivre, la description faisant référence aux dessins annexés parmi lesquels :

- la figure 1 est un schéma d'un circuit électrique comportant un circuit de détection selon l'invention ;
- la figure 2 est un schéma de la logique mise en oeuvre par le circuit de détection de la figure 1 ;
- la figure 3 est un diagramme temporel d'un signal de tension et d'un signal de courant mesuré par des moyens de mesure du circuit de détection de la figure 1 ;
- la figure 4 est un schéma d'un mode de réalisation pour une partie du circuit de détection de la figure 1 ;
- la figure 5 est un diagramme fréquentiel pour la détection d'une fréquence mis en oeuvre dans le schéma de la figure 7 ;
- la figure 6 un diagramme fréquentiel d'un filtre du schéma de la figure 7;
- la figure 7 est un schéma fonctionnel d'un algorithme mis en oeuvre par le circuit de détection de la figure 1 ;
- les figures 8 et 9 sont des diagrammes illustrant le fonctionnement d'une unité de décision illustrée sur la figure 2.

**DESCRIPTION DETAILLEE**

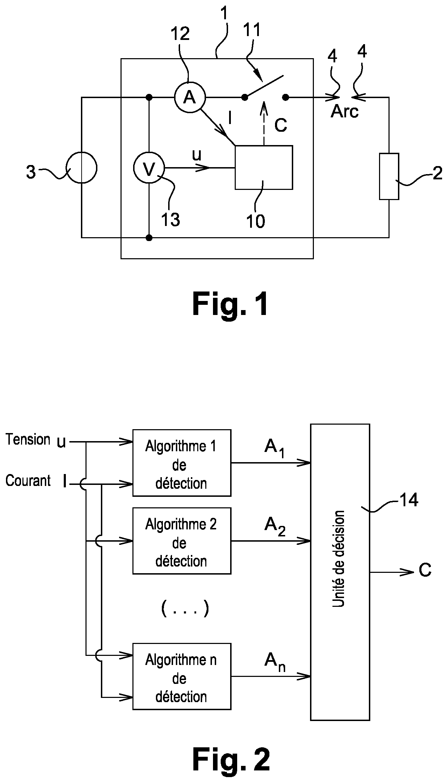

Un circuit électrique est représenté de manière générique sur la figure 1. Un tel circuit comporte une charge 2 alimentée par une source d'alimentation 3 en courant alternatif par l'intermédiaire d'un dispositif de commutation 1 électrique. Un défaut du circuit électrique susceptible de générer un arc électrique est symbolisé par deux touches 4 écartées et se faisant face. La source d'alimentation 3 délivre un courant périodique selon une période d'alimentation.

Le dispositif de commutation 1 comporte un circuit de détection 10 apte à piloter un interrupteur 11 sur au moins une branche du circuit électrique, des moyens de mesure du courant 12 circulant dans le circuit délivrant un signal de courant I au circuit de détection 10 et des moyens de mesure de la tension 13 délivrant un signal de tension U au circuit de détection 10. Le circuit de détection 10 met en oeuvre un procédé de détection d'arc électrique et commande l'ouverture du circuit électrique par l'interrupteur 11 s'il est déterminé qu'un défaut susceptible d'être dangereux a été détecté. Le circuit de détection 10 peut aussi réaliser des fonctions plus classiques de protection contre les surintensités ou de télécommande à distance. Ces fonctions ne sont pas détaillées dans la suite du document.

Le circuit de détection 10 met en oeuvre plusieurs algorithmes de détection 1 à n, afin de détecter plusieurs types d'arcs électriques et de fiabiliser la détection. Comme le montre la figure 2, chaque algorithme reçoit au moins l'un des signaux mesurés (I, U), les analyse puis transmet un signal d'alerte A1 à An à une unité de décision 14. L'unité de décision 14 effectue une synthèse des signaux d'alerte A1 à An et détermine un signal de commande de coupure C pour l'interrupteur 11.

Selon un premier des algorithmes du procédé de détection d'arc électrique, on mesure un signal d'entrée, en l'occurrence le signal de courant I, et on fournit un signal d'alerte A1 indiquant qu'un arc électrique se produit lorsque le signal d'entrée est constant sur au moins une partie de la période d'alimentation.

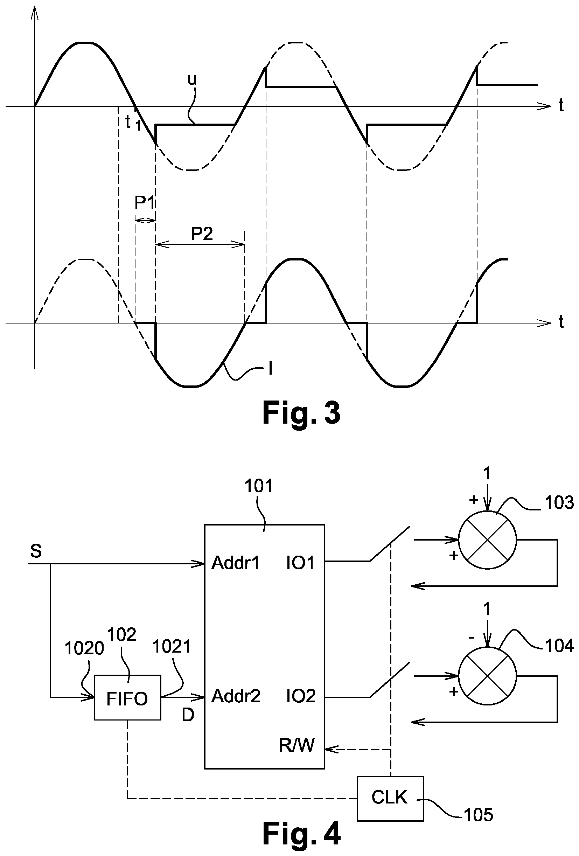

En effet, en se référant à la figure 3, qui montre sur le graphe inférieur le signal de courant I mesuré par les moyens de mesure de courant 12 alors qu'un défaut générant un arc est présent sur le circuit à partir d'un instant t1, le courant se caractérise par une première phase P1 dans laquelle le défaut est un ouverture du circuit et empêche le courant de circuler. Cependant, lorsque la tension d'alimentation est suffisante, un arc s'établit au niveau du défaut et le courant passe par l'arc en retrouvant un niveau correspondant sensiblement à ce qu'il serait en absence de défaut. On trouve donc une forme d'alternance pendant une deuxième phase P2, jusqu'à ce que le courant s'annule à nouveau. L'arc disparaît alors jusqu'à la deuxième phase P2 de la demi période suivante. La première phase P1 correspond donc à une phase pendant laquelle le courant est constant. La détection de cette phase P1 permet de caractériser la présence d'un défaut générant un arc dans le circuit.

De la même manière, en se référant au graphe supérieur de la figure 3 qui montre le signal de tension U mesuré par les moyens de mesure du courant en même temps que le courant I, la tension U suit la tension d'alimentation sinusoïdale dans la première phase P1. Lors de l'apparition de l'arc, la tension U mesurée est déterminée essentiellement par la tension d'entretien de l'arc et apparait donc sensiblement constante. La détection de cette phase P2 de tension constante permet de caractériser la présence d'un défaut générant un arc dans le circuit.

Dans un exemple de réalisation pour mettre en oeuvre le procédé de détection, le circuit de détection 10, tel que montré sur la figure 4, comporte une mémoire de fréquence 101 pour stocker les fréquences des niveaux, une mémoire premier entré-premier sorti 102, des moyens d'addition 103, des moyens de soustraction 104 et une horloge 105. La mémoire de fréquence 101 comporte des registres et un premier bus d'adresse Addr1 recevant une valeur échantillonnée du signal d'entrée S selon des niveaux prédéterminés. Les moyens d'addition 103 sont agencés pour incrémenter de 1 le registre pointé par la valeur fournie sur le premier bus d'adresse Addr1 parmi l'ensemble des registres. La mémoire premier entré-premier sorti 102 reçoit la valeur échantillonnée du signal d'entrée S sur une entrée 1020 et fournit une valeur décalée D sur une sortie 1021. La mémoire de fréquence 101 comporte un deuxième bus d'adresse Addr2 recevant la valeur décalée D depuis la sortie 1021 de la mémoire premier entré-premier sorti 102. Les moyens de soustraction 104 sont agencés pour décrémenter de 1 le registre pointé par la valeur décalée D sur le deuxième bus d'adresse Addr2. L'addition réalisée par les moyens d'addition 103, la soustraction réalisée par les moyens de soustraction 104 et le décalage dans la mémoire premier entré-premier sorti 102 sont réalisés dans un même cycle temporel déterminé par un signal d'horloge CLK fourni par l'horloge 105.

Pour identifier que le signal d'entrée S est constant, on parcourt chaque registre de la mémoire de fréquence 101 et on compare la fréquence de chaque niveau correspondant à un seuil d'alerte prédéterminé, et on délivre le signal d'alerte A1 si la fréquence d'au moins l'un des niveaux est supérieure au seuil d'alerte.

En fonctionnement, l'horloge 105 fonctionne à une fréquence prédéterminée et délivre le signal d'horloge CLK avec une durée de cycle constante. A chaque cycle, la valeur du signal telle qu'échantillonnée est présentée à l'entrée de la mémoire premier entré-premier sorti 102 et est stockée dans ladite mémoire. La valeur est déplacée à chaque cycle dans la mémoire et est présentée sur la sortie de la mémoire premier entré-premier sorti 102 après le nombre de cycles correspondant au nombre de registres de la mémoire premier entré-premier sorti 102, c'est-à-dire après une durée de décalage correspondant au produit de la durée du cycle d'horloge et dudit nombre de registres.

Ainsi, lorsque le signal échantillonné présente une valeur à un instant donné, et que le contenu du registre correspondant est incrémenté de 1 par les moyens d'addition 103, le même registre est décrémenté par les moyens de soustraction 104 après la durée de décalage. Il n'a donc plus d'influence sur le contenu de la mémoire de fréquence 101. Ainsi le contenu de la mémoire de fréquence 101 correspond à l'analyse du signal uniquement sur une fenêtre temporelle prédéterminée, de la durée de décalage. On choisit de préférence cette durée de décalage inférieure à une période d'alimentation. Le signal est échantillonné par exemple sur 8 bits, ce qui correspond à une mémoire de fréquence 101 de 256 registres.

D'autres algorithmes délivrant des signaux d'alerte peuvent être combinés à celui qui vient d'être exposé pour déterminer la commande de coupure du circuit électrique.

Un deuxième algorithme met en oeuvre par exemple une détection par analyse spectrale. Le principe de la détection par analyse spectrale est basé sur la composition du contenu fréquentiel des signaux d'arcs électriques.

On calcule à partir de trois fréquences de bases f0, f0 + mΔf et f0 - mΔf. La formulation proposée s'écrit :

$$B_{f_0} = \frac{\left|A_{f_0 - m\triangle f}\right|^2}{\beta} + \left|A_{f_0}\right|^2 + \frac{\left|A_{f_0 + m\triangle f}\right|^2}{\beta}$$

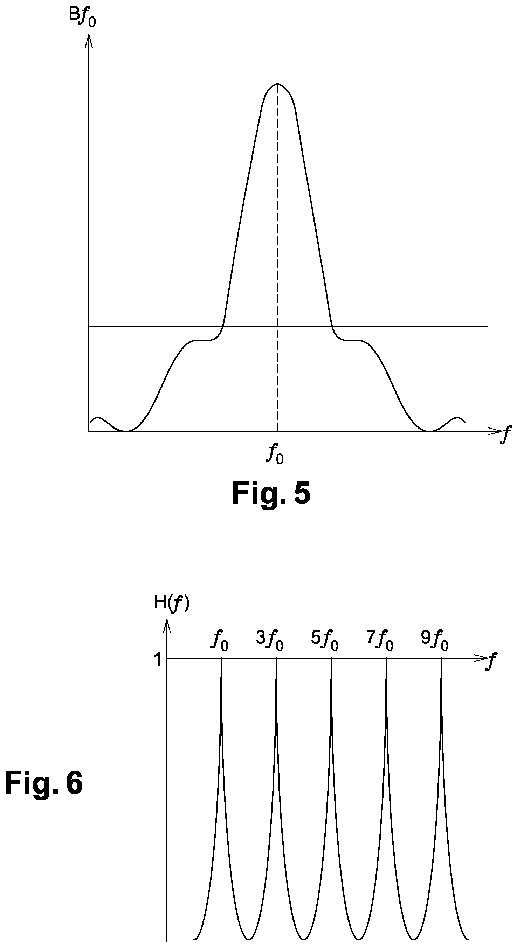

où Af0 est le signal échantilloné et Bf0 est le signal d'analyse fréquentielle. L'écart de fréquence mΔf représente l'écart entre deux fréquences proches et dépend de la résolution Δf utilisée pour l'analyse. Le coefficient $\beta$ est supérieur à 1 et doit être calculé pour que Bf0 soit, d'une part, continuellement croissante entre 0 et f0, et d'autre part, continuellement décroissante entre f0 et l'infini. Lorsque cette condition est respectée, on obtient la courbe de la figure 5.

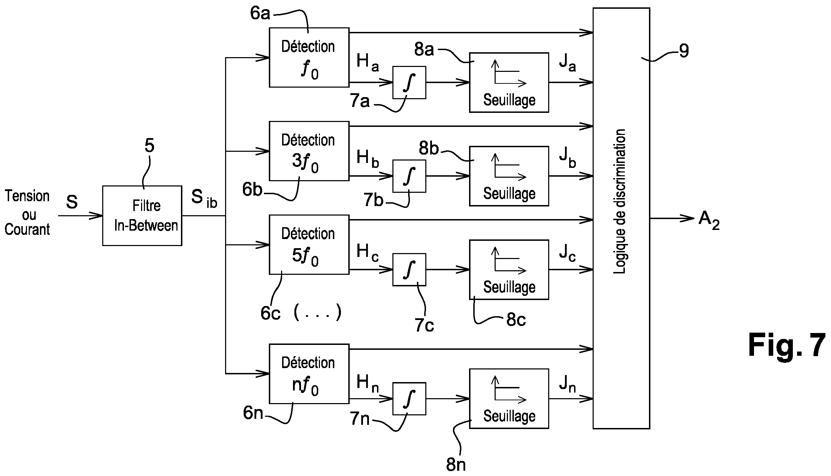

Il est possible de dupliquer ce principe de détection en fonction du nombre d'harmoniques à surveiller. Bien entendu, plus le nombre souhaité est élevé plus la quantité de ressources nécessaires sera importante. Lorsqu'on ne s'intéresse qu'aux harmoniques impairs ou pairs du signal à la fois, on utilise un filtre 5 dit « in between » qui reçoit le signal d'entrée S. Le gabarit idéal du filtre 5 est montré sur la figure 6. Comme le montre le schéma de la figure 7, le signal filtré Sib fourni par le filtre 5 est envoyé en entrée d'une série de détecteurs 6a, 6b, 6c ... 6n de fréquence, chaque détecteur étant dédié à l'une des fréquences en harmonique impair par rapport à une fondamentale f0. Chaque détecteur 6a, 6b, 6c ... 6n applique l'analyse selon la figure 5. Le signal de détection Ha, Hb, Hc... Hn, fourni par chacun des détecteurs 6a, 6b, 6c ... 6n est envoyé à un sommateur 7a, 7b, 7c ... 7n réalisant une sommation sur une fenêtre temporelle glissante. La somme est transmise à un comparateur 8a, 8b, 8c ... 8n qui effectue un seuillage et qui délivre un signal de seuillage Ja, Jb, Jc... Jn, à deux états, en basculant d'un état à l'autre lorsque la somme dépasse une valeur prédéterminée. Les signaux de seuillage Ja, Jb, Jc... Jn et les signaux de détection Ha, Hb, Hc... Hn sont transmis à une unité de synthèse 9 qui délivre un signal d'alerte en fonction de l'ensemble des signaux de seuillage et des signaux de détection. La présence d'un arc est caractérisée par des variations aléatoires, et donc par l'absence d'une dominante. L'unité de synthèse 9 vérifie que les harmoniques sont presque tous présents suffisamment longtemps pour délivrer un signal d'alerte A2 indiquant la présence d'un arc.

Un troisième algorithme met en oeuvre une détection par filtre interpolateur. Cette méthode de détection est basée sur le suréchantillonnage des signaux. Elle fait partie des méthodes de prédictions temporelles. Il s'agit, plus exactement d'une méthode d'interpolation que l'on utilise pour effectuer une prédiction du signal. Le signal d'erreur est ensuite calculé en effectuant la différence entre le signal réel et le signal prédit. La présence d'un défaut d'arc électrique est souvent caractérisée par une variation brutale du signal (soit une chute de tension, soit une élévation de courant) qui induit l'apparition d'un écart. Lorsque l'écart est trop important, un signal d'alarme A3 est déclenché. Cette méthode est basée sur les équations d'interpolation de Lagrange. Elle est décrite en détail dans le document [2] au paragraphe III. Un quatrième algorithme met en oeuvre une méthode de différenciation temporelle. Le principe de cet algorithme est de comparer les valeurs du signal d'entrée S à un écart temporel E correspondant à une ou plusieurs périodes. Pour cela, on évalue la valeur absolue suivante :

$$E(t) = \left| S(t) - S(t-T) \right|$$

où T est un multiple de la période du signal d'entrée S et t est le temps. Sur un circuit électrique sans défaut, le signal d'entrée S est régulier dans sa période, et l'écart d'une période à l'autre est nul. Par contre, si un défaut générant un arc apparait, les périodes successives ne se ressemblent pas, et l'écart n'est plus nul, ce qui permet de générer un signal d'alerte A4.

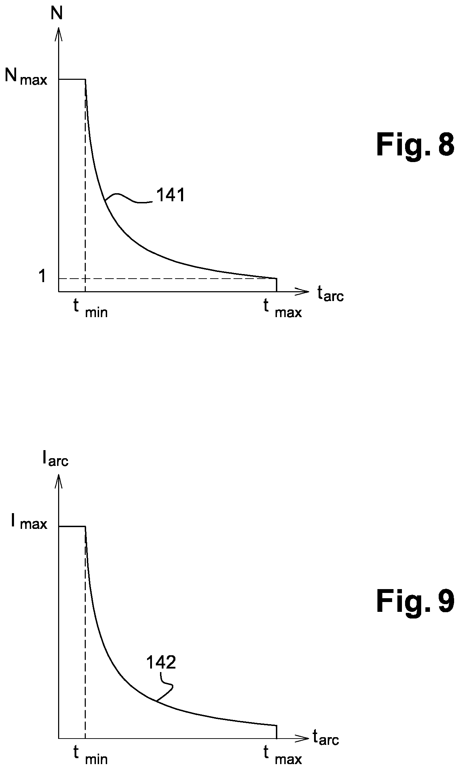

L'unité de décision 14 prend en compte l'ensemble des signaux d'alerte délivrés par les différents algorithmes pour déterminer le signal de commande de coupure C. La détermination de la commande de coupure C prend en compte l'intensité moyenne du signal de courant I pendant l'alerte, la fréquence des signaux d'alerte et leur durée moyenne. Les figures 8 et 9 montrent des diagrammes représentant une première et une deuxième courbe limite en fonction de la durée du signal d'alerte et respectivement de la fréquence de l'arc et de l'intensité de l'arc. La première courbe 141, sur la figure 8, est de forme hyperbolique décroissante, limitée à une durée d'arc limite $t_{max}$ et à une fréquence d'arc limite $N_{max}$. La coupure est commandée si le couple fréquence N des signaux d'alerte et durée moyenne $t_{arc}$ des signaux d'alerte est au-delà de la première courbe 141. La deuxième courbe 142, sur la figure 9, est de forme hyperbolique décroissante, limitée à la durée d'arc limite $t_{max}$ et à une intensité d'arc limite $I_{max}$. La coupure est commandée si le couple intensité d'alerte et durée moyenne $t_{arc}$ est au-delà de la deuxième courbe 142.

### Listes des références

[1] EP 1 845 599 A1 : publié le 17 octobre 2007
[2] « Principle of Arc Fault Detection for Solid State Power Controller », J. Andrea, O. Zirn, M. Bournat, ISBN 978-1-4673-0778-9 in Electrical Contacts (Holm), 2012 IEEE 58th Holm Conference on

### Revendications

1.  Procédé de détection d'arc électrique sur un circuit électrique alimenté en courant alternatif selon une période d'alimentation, selon lequel on mesure au moins un signal d'entrée (S) parmi un courant (I) et une tension (U) d'alimentation du circuit électrique, et on fournit un signal d'alerte (A1) indiquant qu'un arc électrique se produit lorsque le signal d'entrée (S) est constant sur au moins une partie de la période d'alimentation, **caractérisé en ce qu'**on échantillonne numériquement le signal d'entrée (S) lors de sa mesure selon des niveaux prédéterminés et, pour identifier que le signal d'entrée (S) est constant, on détermine la fréquence à laquelle chaque niveau est atteint par le signal d'entrée (S) sur une fenêtre temporelle prédéterminée, on compare la fréquence de chaque niveau à un seuil d'alerte prédéterminé, et on délivre le signal d'alerte si la fréquence d'au moins l'un des niveaux est supérieure au seuil d'alerte.

2.  Procédé selon la revendication 1, selon lequel on utilise :

    - une mémoire de fréquence (101) pour stocker les fréquences des niveaux, la mémoire de fréquence (101) comportant des registres et un premier bus d'adresse (Addr1) recevant la valeur échantillonnée du signal d'entrée (S), on utilise :
    - des moyens d'addition (103) pour incrémenter de 1 l'un des registres pointé par la valeur fournie sur le premier bus d'adresse (Addr1),
    - une mémoire premier entré-premier sorti (102) recevant la valeur échantillonnée du signal d'entrée (S) sur une entrée (1020) et fournissant une valeur décalée (D) sur une sortie (1021), un deuxième bus d'adresse (Addr2) de la mémoire de fréquence (101) recevant la valeur décalée (D), et

- des moyens de soustraction (104) pour décrémenter de 1 le registre pointé par la valeur décalée sur le deuxième bus d'adresse (Addr2), l'addition, la soustraction et le décalage dans la mémoire premier entré-premier sorti (102) étant réalisés dans un même cycle.

3. Procédé selon l'une des revendications précédentes, selon lequel on établit d'autres signaux d'alerte (A2, A3, A4) selon au moins un autre procédé parmi une détection par analyse spectrale, une détection par filtre interpolateur, une méthode de différenciation temporelle, et on combine ces signaux d'alerte (A2, A3, A4) pour déterminer une commande de coupure (C) du circuit électrique.

4. Procédé selon la revendication 3, selon lequel le signal d'entrée (S) est le signal de courant (I), la détermination de la commande de coupure (C) prenant en compte l'intensité du signal de courant (I) pendant l'alerte, la fréquence des signaux d'alerte (N) et leur durée moyenne ($t_{arc}$).

5. Procédé selon la revendication 4, selon lequel la coupure est commandée si un couple fréquence (N) des signaux d'alerte et durée moyenne ($t_{arc}$) des signaux d'alerte est au-delà d'une première courbe (141) de forme hyperbolique décroissante, ou si un couple intensité d'alerte et durée moyenne est au-delà d'une deuxième courbe (142) de forme hyperbolique décroissante.

6. Circuit de détection pour détecter la présence d'arc électrique sur un circuit électrique alimenté en courant alternatif selon une période d'alimentation, le circuit de détection (10) comportant des moyens de mesure (12, 13) pour établir au moins un signal d'entrée (S) parmi un signal de tension (U) et un signal de courant (I) représentatif respectivement de la tension (U) et de l'intensité (I) alimentant le circuit électrique, le circuit de détection (10) étant agencé pour délivrer un signal d'alerte (A1) indiquant qu'un arc électrique se produit lorsque le signal d'entrée (S) est constant sur au moins une partie de la période d'alimentation, le circuit étant **caractérisé en ce qu'**il comporte des moyens d'échantillonnage pour échantillonner numériquement le signal d'entrée (S) lors de sa mesure selon des niveaux prédéterminés et des moyens de traitement pour identifier que le signal d'entrée (S) est constant, en déterminant la fréquence à laquelle chaque niveau est atteint par le signal d'entrée (S) sur une fenêtre temporelle prédéterminée, en comparant la fréquence de chaque niveau à un seuil d'alerte prédéterminé, et en délivrant le signal d'alerte si la fréquence d'au moins l'un des niveaux est supérieure au seuil d'alerte.

7. Dispositif de commutation électrique comportant des moyens de commutation (11) pour ouvrir et fermer un circuit électrique alimenté en courant alternatif selon une période d'alimentation et un circuit de détection (10) pour piloter les moyens de commutation (11), **caractérisé en ce que** le circuit de détection (10) est conforme à la revendication 6.

## Patentansprüche

1. Verfahren zur Erfassung eines elektrischen Lichtbogens in einem elektrischen Schaltkreis, der gemäß einer Versorgungsperiode mit Wechselstrom versorgt wird, gemäß dem mindestens ein Eingangssignal (S) von einem Strom (I) und einer Spannung (U) der Versorgung des elektrischen Schaltkreises gemessen und ein Warnsignal (A1) bereitgestellt wird, das anzeigt, dass ein elektrischer Lichtbogen entsteht, wenn das Eingangssignal (S) über mindestens einen Teil der Versorgungsperiode konstant ist, **dadurch gekennzeichnet, dass** das Eingangssignal (S) bei seiner Messung gemäß vorbestimmten Niveaus digital gesampelt und, um festzustellen, dass das Eingangssignal (S) konstant ist, die Frequenz bestimmt wird, bei der jedes Niveau des Eingangssignals (S) in einem vorbestimmten temporären Fenster erreicht, die Frequenz jedes Niveaus mit einer vorbestimmten Warnstufe verglichen und das Warnsignal ausgegeben wird, wenn die Frequenz von mindestens einem der Niveaus über der Warnstufe liegt.

2. Verfahren nach Anspruch 1, wobei verwendet wird:

- ein Frequenzspeicher (101), um die Frequenzen der Niveaus zu speichern, wobei der Frequenzspeicher (101) Register und einen ersten Adressbus (Addr1) umfasst, der den gesampelten Wert des Eingangssignals (S) empfängt,
- Additionsmittel (103), um eines der durch den in dem ersten Adressbus (Addr1) bereitgestellten Wert angesprochene Register um 1 zu inkrementieren,
- einen First-in-first-out-Speicher (102), der den gesampelten Wert des Eingangssignals (S) über einen Eingang (1020) empfängt und einen versetzten Wert (D) über einen Ausgang (1021) bereitstellt, wobei ein zweiter Adressbus (Addr2) des Frequenzspeichers (101) den versetzten Wert (D) empfängt, und
- Subtraktionsmittel (104), um das durch den in dem zweiten Adressbus (Addr2) versetzten Wert angesprochene Register um 1 zu dekrementieren, wobei die Addition, die Subtraktion und der Versatz in dem First-in-first-out-Speicher (102) in einem selben Zyklus durchgeführt werden.

3. Verfahren nach einem der vorangehenden Ansprüche, wobei weitere Warnsignale (A2, A3, A4) gemäß mindestens einem anderen Verfahren aus einer Erfassung durch Spektralanalyse, einer Erfassung durch interpolierenden Filter, einer Methode der temporären Differenzierung erstellt und diese Warnsignale (A2, A3, A4) kombiniert werden, um einen Unterbrechungsbefehl (C) des elektrischen Schaltkreises zu bestimmen.

4. Verfahren nach Anspruch 3, wobei das Eingangssignal (S) das Stromsignal (I) ist, wobei die Bestimmung des Unterbrechungsbefehls (C) die Stärke des Stromsignals (I) während der Warnung, die Frequenz der Warnsignale (N) und ihre durchschnittliche Dauer ($t_{arc}$) berücksichtigt.

5. Verfahren nach Anspruch 4, wobei die Trennung befohlen wird, wenn sich ein Paar Frequenz (N) der Warnsignale und durchschnittliche Dauer ($t_{arc}$) der Warnsignale jenseits einer ersten Kurve (141) mit abnehmender hyperbolischer Form befindet oder wenn sich ein Paar Stärke der Warnung und durchschnittliche Dauer jenseits einer zweiten Kurve (142) abnehmender hyperbolischer Form befindet.

6. Erfassungsschaltkreis zwecks Erfassung der Anwesenheit eines elektrischen Lichtbogens in einem elektrischen Schaltkreis, der gemäß einer Versorgungsperiode mit Wechselstrom versorgt wird, wobei der Erfassungsschaltkreis (10) Messmittel (12, 13) umfasst, um mindestens ein Eingangssignal (S) von einem Spannungssignal (U) und einem Stromsignal (I) zu ermitteln, das jeweils für die Spannung (U) und die Stromstärke (I) repräsentativ ist, welche den elektrischen Schaltkreis versorgen, wobei der Erfassungsschaltkreis (10) ausgebildet ist, um ein Warnsignal (A1) auszugeben, das anzeigt, dass ein elektrischer Lichtbogen entsteht, wenn das Eingangssignal (S) über mindestens einen Teil der Versorgungsperiode konstant ist, wobei der Schaltkreis **dadurch gekennzeichnet ist, dass** er Sampelmittel aufweist, um das Eingangssignal (S) bei seiner Messung gemäß vorbestimmten Niveaus digital zu sampeln und Verarbeitungsmittel, um festzustellen, dass das Eingangssignal (S) konstant ist, durch Bestimmen der Frequenz, zu der jedes Niveau von dem Eingangssignal (S) in einem vorbestimmten temporären Fenster erreicht wird, durch Vergleichen der Frequenz jedes Niveaus mit einer vorbestimmten Warnstufe und durch Ausgeben des Warnsignals, wenn die Frequenz von mindestens einem der Niveaus über der Warnstufe liegt.

7. Elektrische Umschaltvorrichtung, aufweisend Umschaltmittel (11) zum Öffnen und Schließen eines elektrischen Schaltkreises, der gemäß einer Versorgungsperiode mit Wechselstrom versorgt wird, und eines Erfassungsschaltkreises (10), um die Umschaltmittel (11) zu steuern, **dadurch gekennzeichnet, dass** der Erfassungsschaltkreis (10) Anspruch 6 entspricht.

## Claims

1. A method for detecting an electrical arc in an electrical circuit powered with alternating current according a power supply period, according to which at least one input signal (S) from between a power supply current (I) and a power supply voltage (U) for the electrical circuit is measured, and a warning signal is supplied (A1) indicating that electrical arc is occurring when the input signal (S) is constant over at least a part of the power supply period, **characterized in that** the input signal (S) is digitally sampled when it is measured according to predetermined levels and, in order to identify that the input signal (S) is constant, the frequency at which each level is reached by the input signal (S) is determined over a predetermined time window, the frequency of each level is compared with a predetermined warning threshold, and the warning signal is delivered if the frequency of at least one of the levels is greater than the warning threshold.

2. The method as claimed in claim 1, according to which the following are used:

- a frequency memory (101) for storing the frequencies of the levels, the frequency memory (101) comprising registers and a first address bus (Addr1) receiving the sampled value of the input signal (S),
- addition means (103) for incrementing by 1 one of the registers to which the value supplied on the first address bus (Addr1) points,
- a first in-first out memory (102) receiving the sampled value of the input signal (S) on an input (1020) and supplying a shifted value (D) on an output (1021), a second address bus (Addr2) of the frequency memory (101) receiving the shifted value (D), and

- subtraction means (104) for decrementing by 1 the register to which the shifted value on the second address bus (Addr2) points, the addition, the subtraction and the shift in the first in-first out memory (102) being carried out within the same cycle.

3. The method as claimed in the preceding claims, according to which other warning signals (A2, A3, A4) are established according to at least one other method from amongst a detection by spectral analysis, a detection by interpolation filter, a time differentiation method, and these warning signals are combined (A2, A3, A4) for determining a turn-off command (C) for the electrical circuit.

4. The method as claimed in claim 3, according to which the input signal (S) is the current signal (I), the determination of the turn-off command (C) taking into account the intensity of the current signal (I) during the warning period, the frequency of the warning signals (N) and their average duration ($t_{arc}$).

5. The method as claimed in claim 4, according to which a cut-out command is issued if a pair frequency (N) of the warning signals and average duration ($t_{arc}$) of the warning signals is above a first curve (141) with a decreasing hyperbolic form, or if a pair warning current intensity and average duration is above a second curve (142) with a decreasing hyperbolic form.

6. A detection circuit for detecting the presence of an electrical arc in an electrical circuit powered with alternating current according to a power supply period, the detection circuit (10) comprising measurement means (12, 13) for establishing at least one input signal (S) from between a voltage signal (U) and a current signal (I) respectively representative of the voltage (U) and of the current intensity (I) supplying the electrical circuit, the detection circuit (10) being configured for delivering a warning signal (A1) indicating that an electrical arc is occurring when the input signal (S) is constant over at least a part of the power supply period, the circuit being **characterized in that** it comprises sampling means for digitally sampling the input signal (S) when it is measured according to predetermined levels and processing means for identifying that the input signal (S) is constant, determining the frequency at which each level is reached by the input signal (S) over a predetermined time window, comparing the frequency of each level with a predetermined warning threshold, and delivering the warning signal if the frequency of at least one of the levels is greater than the warning threshold.

7. An electrical switching device comprising switching means (11) for opening and closing an electrical circuit powered with alternating current according to a power supply period and a detection circuit (10) for controlling the switching means (11), **characterized in that** the detection circuit (10) is as claimed in claim 6.

**Fig. 1**

**Fig. 2**

Fig. 3

Fig. 4

**Fig. 5**

**Fig. 6**

EP 3 103 178 B1

Fig. 7

N

N max

141

1

t min          t max          t arc

**Fig. 8**

I arc

I max

142

t min          t max          t arc

**Fig. 9**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1845599 A1
- US 6504692 B1
- EP 0639879 A2
- EP 1443622 A2

**Littérature non-brevet citée dans la description**

- **J. ANDREA ; O. ZIRN ; M. BOURNAT.** Principle of Arc Fault Detection for Solid State Power Controller. *Electrical Contacts (Holm), 2012 IEEE 58th Holm Conference on,* 2012, ISBN 978-1-4673-0778-9